# EUROPEAN PATENT APPLICATION

(11) **EP 1 367 438 A2**
(43) Date of publication of application: **03.12.2003**
(21) Application number: 02027628.3
(22) Date of filing: 11.12.2002
(51) Int. Cl.: G03F 7/00

(54) **Insulating resin film and method of forming fine patterns of insulating resin film**

(30) Priority: 31.05.2002 JP 2002159326
(71) Applicant: Tohoku Pioneer Corporation, Tendo-shi, Yamagata-ken (JP)
(72) Inventor: Takashi, Toshiharu, Tohoku Pioneer Corporation, Tendo-shi, Yamagata-ken 994-0012 (JP)
(74) Representative: Popp, Eugen, Dr.

(57) **Abstract**

An insulating resin film (20) having fine patterns in the order of microns is provided, with which good economies of mass production can be attained and the material restriction can be eased. Also provided is a method of forming fine patterns of the insulating resin film. An insulating resin film (20) to be subjected to molding is placed on a forming mold (10) provided with molding slots (10a) for forming fine patterns, and a drape forming mold (30) provided with concave portions (30a) in a one-to-one correspondence with the molding slots (10a) is placed thereon. The insulting resin film (20) is attracted toward the drape forming mold (30) through suction and fine drape portions (20a) corresponding to the fine patterns are formed inside the concave portions (30a). Then, the drape portions (20a) are pulled inside the molding slots (10a).

## Description

### BACKGROUND OF THE INVENTION

The present invention relates to an insulating resin film having fine patterns in the order of microns, and to a method of forming fine patterns of such an insulating resin film.

The present application claims priority from Japanese Application No.2002-159326, the disclosure of which is incorporated herein by reference for all purposes.

As various kinds of electronic/electrical components including semi conductors have been increasing in packing densities and decreasing in size, a technique for forming fine patterns in the order of microns (fine pitch) in a thin insulating resin film is becoming increasingly important to achieve high-density packaging or high-density wiring with such electronic/electrical components or wiring boards.

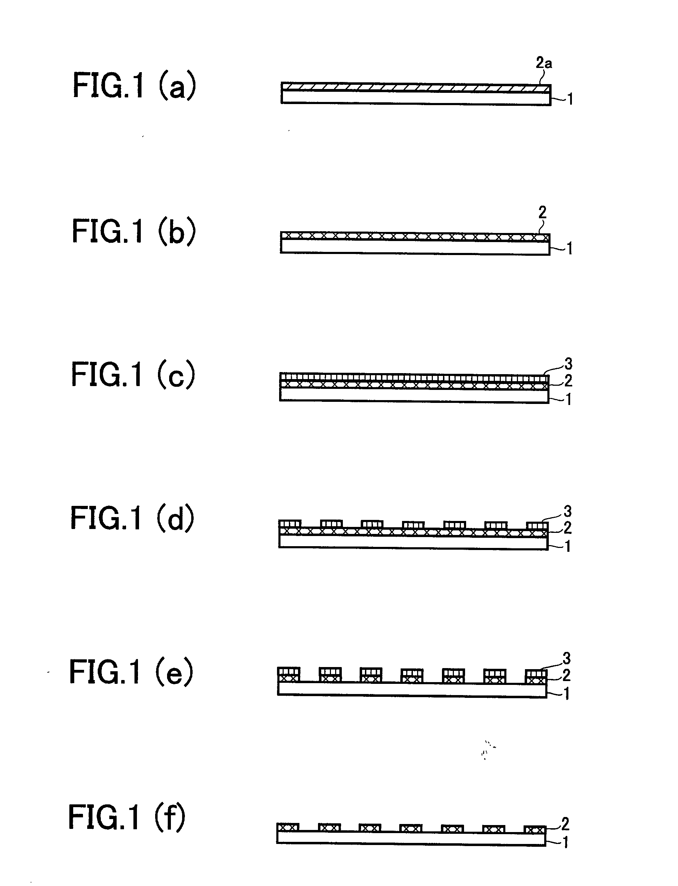

However, it is the present circumstances that there is not any practical method other than the method employing the photolithographic technique for forming fine patterns in the order of microns in a thin insulating resin film. The following description will describe, with reference to Figs. 1(a) through 1(f), a method of forming fine patterns employing the conventional photolithographic technique (see Japanese Patent Laid-Open Publication No. Hei. 5-23876).

According to this conventional technique, as shown in Fig. 1 (a), an insulating layer 2a made of highly insulative resin is formed on a substrate 1 made of alumina ceramic, for example. Then, as shown in Fig. 1(b), polyimide precursor varnish is applied uniformly to an entire upper surface of the substrate 1 through any applicable coating method (spin coating or the like), and heat treatment is applied at 350 to 400°C for 10 to 20 minutes. An insulating layer 2 made of polyimide resin, which is highly insulative resin, is thus formed on the substrate 1. Then, as shown in Fig. 1(c), the entire surface of the insulating layer 2 is coated uniformly with a photoresist liquid, and the photoresist liquid is allowed to cure with heating at 70 to 100°C. The surface of the insulating layer 2 is thereby covered with a photoresist film 3. Then, as shown in Fig. 1 (d), a desired pattern is exposed to light and developed to expose unwanted portions of the insulating layer 2 to air. Then, as shown in Fig. 1(e), the exposed unwanted portions of the insulating layer 2 are removed through etching using the photoresist film 3 as an etching mask. Finally, as shown in Fig. 1 (f), the photoresist film 3 is removed. The insulating layer 2 having fine patterns is thus formed on the substrate 1.

According to the method of forming fine patterns of an insulating resin film employing the photolithographic technique described as above, it is possible to form patterns in the order of microns with accuracy; however, there is a problem that the fabrication sequence is complicated and high manufacturing costs results in poor economies of mass production. Also, since processing is carried out through etching of various types (wet etching, dry etching, etc.), the insulating resin film needs to be made of a material having satisfactory workability in etching process, a resin having a good film-forming ability. Hence, the insulating resin film has a problem that it cannot be used in a wide range of applications.

### SUMMARY OF THE INVENTION

The invention is addressed to solve each of the foregoing problems, and in particular, it is an object of the invention to provide an insulating resin film which can attain excellent economies of mass production and can be used in a wide range of applications without receiving any restriction on materials. Another object of the invention is to provide a method of forming fine patterns of the insulating resin film.

In order to achieve the above and other objects, the invention provides characteristics as follows.

According to a first aspect of the present invention, there is provided an insulating resin film molded to have concavo-convex patterns at a pitch of 10 to 500 µm through vacuum pressure forming.

According to a second aspect of the present invention, there is provided an insulating resin film molded to have concavo-convex patterns having a depth of 10 to 500 µm at a pitch of 10 to 500 µm through vacuum pressure forming.

According to a third aspect of the present invention, there is provided a method of forming fine patterns of an insulating resin film including: a step of placing the insulating resin film on a forming mold provided with fine concavo-convex patterns formed at a predetermined pitch; a drape forming step of placing a drape forming mold provided with fine concavo-convex patterns corresponding to the fine patterns of the forming mold on or above the insulating resin film, and forming drape portions corresponding to the fine patterns of the forming mold in the insulting resin film; and a molding step of molding the insulating resin film to have the fine concavo-convex patterns by press-adhering the respective drape portions to the corresponding fine patterns of the forming mold.

### BRIEF DESCRIPTION OF THE DRAWINGS

These and other objects and advantages of the present invention will become clear from the following description with reference to the accompanying drawings, wherein:
Figs. 1(a) through 1(f) are explanatory views explaining a method of forming fine patterns through the use of conventional photolithographic techniques;
Figs. 2(a) through 2(e) are explanatory views showing a method of forming fine patterns according to one embodiment of the invention;
Figs. 3 (a) and 3 (b) are explanatory views showing the method of forming fine patterns according to another embodiment of the invention;
Figs. 4(a) through 4(c) are explanatory views showing the method of forming fine patterns according to still another embodiment of the invention;
Figs. 5(a) through 5(d) are explanatory views showing the method of forming fine patterns according to still another embodiment of the invention;
Fig. 6 is an explanatory view showing a dimension of an insulating resin film having molded fine patterns;
Fig. 7 is an explanatory view showing a high-density wiring electronic component in which a conducting member is provided in the fine patterns of the insulating resin film shown in Fig. 6;
Figs. 8 (a) and 8 (b) are explanatory views showing a flexible wiring board as an example of a high-density wiring electronic component utilizing the insulating resin film formed in the above embodiments;
Fig. 9 is an explanatory view showing one example of a molding apparatus for molding the insulating resin film; and
Figs. 10 (a) through 10 (f) are explanatory views showing one example of a method of forming fine patterns using the molding apparatus.

### DETAILED DESCRIPTION OF THE PREFERRED EMBODIMENTS

The following description will describe various embodiments of the invention in correspondence with the respective characteristics thereof.

A first characteristic is that fine concavo-convex patterns can be formed in an insulating resin film through the use of a forming mold, and the insulating resin film of the embodiments of the invention is characterized in that it is molded to concavo-convex patterns at a pitch of 10 to 500 µm through vacuum pressure forming using a forming mold.

According to this characteristic, contrary to the conventional method in which it is general to form fine patterns in the order of microns through photolithographic techniques, fine patterns are formed through the use of the forming mold, which makes it possible to improve the productivity. Further, since molding through the use of a forming mold can ease the restriction of the kinds of materials, it is possible to obtain an insulating resin film which can be used in a wide range of applications.

A second characteristic is that fine concavo-convex patterns can be formed in an insulating resin film through the use of a forming mold, and the insulating resin film of the embodiments of the invention is molded to have concavo-convex patterns having a depth of 10 to 500 µm at a pitch of 10 to 500 µm. According to this characteristic, the concavo-convex patterns having a depth of 10 to 500 µm are formed at a pitch of 10 to 500 µm through the use of the forming mold. Hence, not only can the productivity of the insulating resin film having fine patterns be improved, but also such an insulating resin film can be used in a wide range of applications since it receives only decreased restriction of the kinds of selectable materials.

A third characteristic is that the insulating resin film having the first or second characteristic has concavo-convex patterns having any of gib-shaped, V-shaped, and U-shaped cross sections, either solely or in combination. According to this characteristic, an insulating resin film having the cross section of any of the foregoing shapes can be obtained at improved productivity with reduced restriction of the kinds of materials.

A fourth characteristic is that a high-density wiring electronic component is made of the insulating resin film having any one of the above-described first through third characteristics, in which a conducting member is provided inside concave portions of the concavo-convex patterns. According to this characteristic, the high-density wiring electronic component made of the insulating resin film having fine patterns can be obtained at improved productivity with a wide choice of options being offered for material designs because of the reduced restriction of the kinds of insulating materials.

A fifth characteristic is that a high-density wiring electronic component is made of the insulating resin film having the fourth characteristic, in which the insulating resin film has a thickness of 5 to 500 µm. According to this characteristic, the high-density wiring electronic component made of an insulating resin film having a thickness and fine patterns both in the order of microns can be obtained at an improved productivity with a wide choice of options being offered for material designs because of the reduced restriction of the kinds of insulating materials.

A sixth characteristic is that a high-density wiring electronic component is made of the insulating resin film having the fourth or fifth characteristic, in which the insulating resin film is made of any one of polyimide, polyamide, polybenzimidazole, polyester, polyimidazole, polyphenylenesulfide,polyamide-imide, polyether imide, polyether ketone, and polysulfone. According to this characteristic, a high-density wiring electronic component made of an insulating resin film having a thickness or fine patterns in the order of microns can be obtained at improved productivity using the foregoing materials having heat resistance and good insulation properties.

The following description will describe embodiments of the method of forming fine patterns of the insulating resin film having the characteristics described as above.

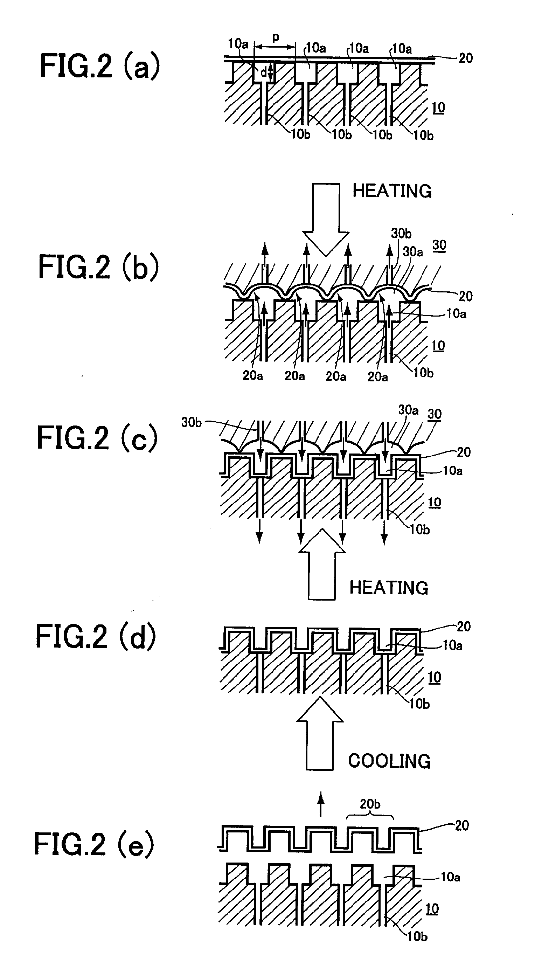

Figs. 2 (a) through 2(e) are explanatory views showing the method of forming fine patterns, according to one embodiment of the invention. In the drawings, the reference numeral 10 denotes a forming mold for forming fine concavo-convex patterns, and the forming mold 10 is provided with molding slots 10a corresponding to the fine patterns as striped patterns having a gib-shaped cross section, for example. The pitch p and the depth d of the molding slots 10a are in the order of microns, for example, 10 to 500 µm. Also, the forming mold 10 is provided with vent holes 10b communicating with the respective molding slots 10a.

The method of forming fine patterns of this embodiment will be explained step by step with reference to the drawings. As shown in Fig. 2 (a) , an insulating resin film 20 to be subjected to molding is placed on the forming mold 10. Then, as shown in Fig. 2(b), a drape forming mold 30 provided with fine concavo-convex patterns corresponding to the fine patterns of the forming mold 10 is placed on the insulating resin film 20. The drape forming mold 30 is provided with concave portion spaces 30a in a one-to-one correspondence with the molding slots 10a, and these concave portion spaces 30a form the fine concavo-convex patterns. The drape forming mold 30 is also provided with vent holes 30b communicating with the respective concave portion spaces 30a.

In the drape forming step shown in Fig. 2 (b) , drape portions 20a corresponding to the fine patterns of the forming mold 10 are formed in the insulating resin film 20 through the use of the drape forming mold 30. To be more specific, either or both of suction from the drape forming mold 30 side via the vent holes 30b and air-compression from the forming mold 10 side via the vent holes 10b are exerted with respect to the insulating resin film 20, and the insulating resin film 20 is thereby pulled inside the concave portion spaces 30a. The drape portions 20a corresponding to the fine patterns of the concave portion spaces 30a are thus formed in the insulating resin film 20. At this point, the drape forming mold 30 is heated as needed. By heating the drape forming mold 30, pre-heating for molding can be also conducted during the drape forming, and the drape forming can be conducted more effectively.

In the molding step shown in Fig. 2 (c), the respective drape portions 20a described as above are press-adhered to the corresponding fine patterns of the forming mold 10 to mold the insulating resin film 20 to fine concavo-convex patterns. To be more specific, in this molding step, either or both of air-compression from the drape forming mold 30 side via the vent holes 30b and suction from the forming mold 10 side via the vent holes 10b are exerted with respect to the insulating resin film 20, and the drape portions 20a of the insulating resin film 20 are thereby pulled inside the molding slots 10a. The insulating resin film 20 is thus molded to have the fine patterns corresponding to the molding slots 10a. At this point, the forming mold 10 is heated as needed. This heating can further ensure the molding of the fine patterns.

When this molding step ends, as shown in Fig. 2 (d) , the forming mold 10 is cooled as needed. This cooling cures the insulating resin film 20 previously softened by heating, and allows the molded fine patterns to be maintained in the exact shape. Then, as shown in Fig. 2(e), mold release is conducted. The insulating resin film 20 molded to fine-pitched fine patterns 20b is thus obtained.

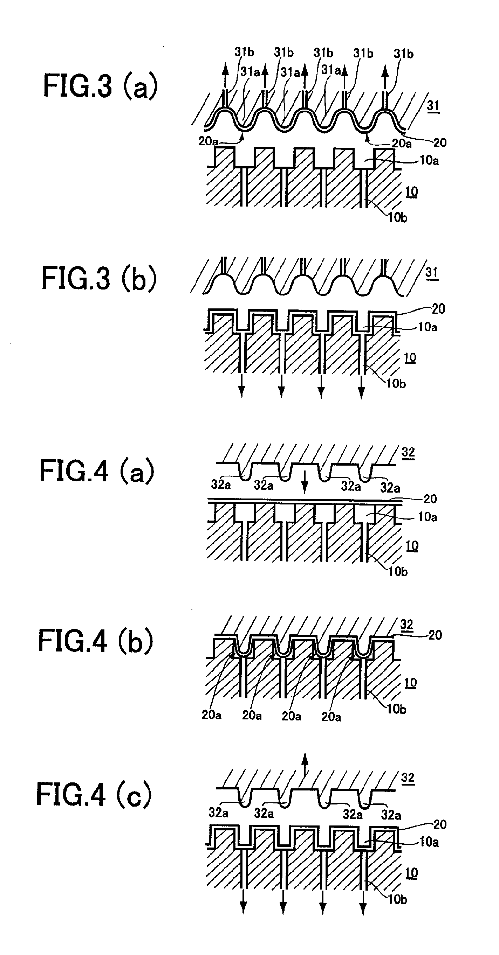

Figs. 3 (a) and 3 (b) are explanatory views showing the method of forming fine patterns, according to another embodiment of the invention. Like components are labeled with like reference numerals with respect to the embodiment above, and part of the description of these components is omitted for easy explanation. In this embodiment, a drape forming mold 31 provided with convex portions 31a corresponding to the molding slots 10a forming the fine patterns of the forming mold 10 is used. Alpha-numeral 31b denotes vent holes for attracting the insulating resin film 20 toward the drape forming mold 31 through suction.

The method of forming fine patterns of this embodiment will be explained step by step with reference to the drawings. As shown in Fig. 2 (a) , the insulating resin film 20 to be subjected to molding is placed on the forming mold 10. Further, the drape forming mold 31 is placed above the insulating resin film 20. Then, a drape forming step as shown in Fig. 3(a) is conducted.

In this drape forming step, suction from the drape forming mold 31 side is conducted via the vent holes 31b. The resin film 20 is thereby press-adhered to the drape forming mold 31. The drape forming mold 31 is provided with the convex portions 31a in a one-to-one correspondence with the molding slots 10a of the forming mold 10 as described above. Hence, drape portions 20a corresponding to the fine patterns of the forming mold 10 are formed in the insulating resin film 20 by these convex portions 31a. At this point, the drape forming mold 31 is heated as needed. By heating the drape forming mold 31, pre-heating for molding can be also conducted during the drape forming, and the drape forming can be conducted more effectively.

In the molding step shown in Fig. 3(b), suction is exerted with respect to the insulating resin film 20 from the forming mold 10 side via the vent holes 10b, and the drape portions 20a of the insulating resin film 20 are thereby pulled inside the molding slots 10a. The insulating resin film 20 is thus molded to have the fine patterns corresponding to the molding slots 10a. At this point, the forming mold 10 is heated as needed. This heating further ensures the molding of the fine patterns. Thereafter, cooling is conducted as needed as with the embodiment above, and by conducting the mold release, an insulating resin film on which are formed fine patterns in the order of microns can be obtained.

Figs. 4(a) through 4(c) are explanatory views showing the method of forming fine patterns, according to still another embodiment of the invention. Like components are labeled with like reference numerals with respect to the embodiments above, and part of the description of these components is omitted for easy explanation. In this embodiment, a drape forming mold 32 provided with convex portions 32a in a one-to-one correspondence with the molding slots 10a of the forming mold 10 is used, and the drape forming mold 32 is press-adhered to the insulating resin film 20 placed on the forming mold 10 (see Fig. 4 (a)) . The drape portions 20a are thereby formed in the insulating resin film 20 inside the molding slots 10a of the forming mold 10 (the drape forming step, see Fig. 4(b)). Then, the drape forming mold 32 is released, and suction from the forming mold 10 side is exerted with respect to the insulating resin film 20 via the vent holes 10b, and the drape portions 20a formed inside the molding slots 10a are thereby press-adhered to the inner surface of the molding slots 10a. The insulting resin film 20 is thus molded to have the fine patterns corresponding to the molding slots 10a. At this point, the forming mold 10 is heated as needed as with the embodiments above. Thereafter, cooling is conducted as needed as with the embodiments above, and by conducting the mold release, an insulating resin film on which are formed the fine patterns in the order of microns can be obtained.

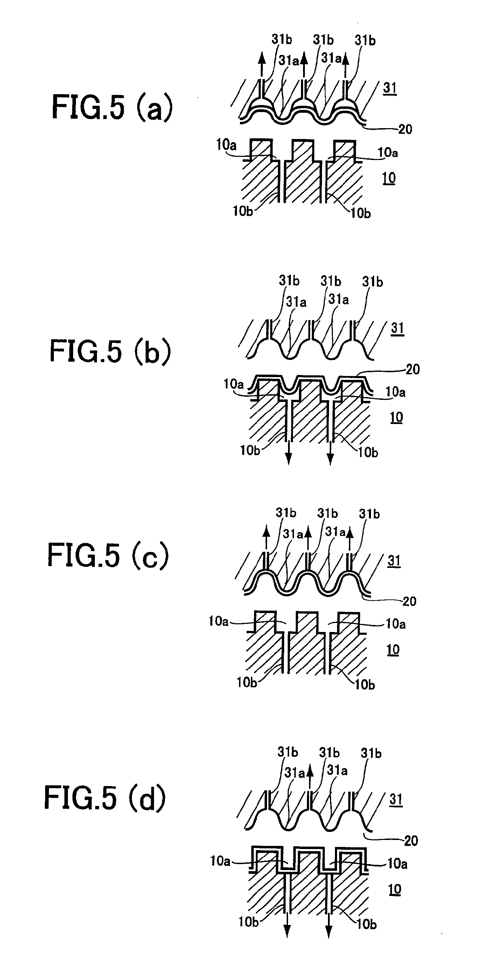

Figs. 5(a) through 5(d) are explanatory views showing a method of forming fine patterns, according to still another embodiment of the invention. Like components are labeled with like reference numerals with respect to the embodiments above, and part of the description of these components is omitted for easy explanation. In this embodiment, the drape forming step and the molding step as described in each of the embodiments above are repeated alternately in succession.

The embodiment shown in Figs. 5(a) through 5(d) uses the embodiment shown in Figs. 3(a) and 3(b) as an example. In Fig. 5 (a) , drape portions are formed partially in the insulating resin film 20 through suction from the drape forming mold 31 side via the vent holes 31b in the drape forming step. Then, as shown in Fig. 5(b), in the molding step, the partial drape portions thus formed are pulled inside the molding slots 10a to be expanded further. Then, as shown in Fig. 5(c), drape portions corresponding to the convex portions 31a of the drape forming mold 31 are formed through suction from the drape forming mold 31 side. Finally, as shown in Fig. 5(d), the drape portions are pulled inside the molding slots 10a through suction from the forming mold 10 side, and the drape portions are thereby press-adhered to the inner surface of the molding slots 10a. These steps can be repeated more than once step by step. The steps before and after the steps described herein are the same as those in the embodiments above.

The following description will continue to describe the embodiments of the method of forming fine patterns of the insulating resin film in correspondence with the respective characteristics of the invention in addition to the foregoing characteristics.

A seventh characteristic is that the method includes: a step of placing an insulating resin film 20 on a forming mold 10 provided with fine concavo-convex patterns (molding slots 10a) formed at a predetermined pitch; a drape forming step of placing a drape forming mold 30 provided with fine concavo-convex patterns (concave portion spaces 30a) corresponding to the fine patterns of the forming mold 10 on or above the insulating resin film 20, and forming drape portions 20a corresponding to the fine patterns of the forming mold 10 in the insulting resin film 20; and a molding step of molding the insulating resin film 20 to have the fine concavo-convex patterns by press-adhering the respective drape portions 20a to the corresponding fine patterns of the forming mold 10.

According to this characteristic, because fine patterns can be formed in the insulating resin film through the use of the forming mold, the forming of fine patterns suitable for mass production is made possible at a low cost. Hence, not only can the productivity be improved, but also fine patterns in the order of microns can be formed in an insulating resin film made of a material suitable for a given application, without receiving any restriction on materials.

To be more concrete, in this embodiment, the characteristic step which makes it possible to form fine patterns through molding is the drape forming step for forming fine drape portions corresponding to the fine patterns in the insulating resin film. In other words, the drape forming step is normally performed as a pre-blow molding step or a plug-assist molding step in the vacuum forming or the vacuum pressure forming conventionally known as the method of molding the insulating resin film. However, it is impossible to form fine patterns in the order of microns in the insulating resin film with satisfactory transferring properties in the drape forming step of the conventional vacuum forming or vacuum pressure forming. The reason why is as follows. That is, because the draping effect cannot be exerted uniformly within the molding plane in the draping step for applying pre-blow or plug-assist to the entire insulating resin film (which is the material to be subjected to molding), when corresponded to the fine patterns, portions extended exceedingly or portions extended unsatisfactorily correspond to the respective fine patterns, and the exact fine patterns cannot be transferred.

On the contrary, in the drape forming step described in this embodiment, the drape forming mold 30 provided with fine concavo-convex patterns (concave portion spaces 30a) corresponding to the fine patterns of the forming mold 10 is placed above the insulating resin film 20, and the drape portions 20a corresponding to the fine patterns of the forming mold 10 are formed in the insulating resin film 20. Hence, it is possible to bring the uniform drape portions 20a into correspondence with the respective fine patterns of the forming mold 10. Thus, by press-adhering the drape portions 20a to the interior of the respective fine patterns of the forming mold 10, it is possible to form fine patterns in the order of microns in the insulating resin film 20 through molding.

An eighth characteristic is based on the foregoing characteristic, in which, in the drape forming step, the drape portions 20a are formed in the concave portion spaces 30a of the fine patterns of the drape forming mold 30 through either or both of suction from the drape forming mold 30 side and air-compression from the forming mold 10 side. According to this characteristic, together with the foregoing characteristic, the drape portions 20a are formed without any physical contact through a vacuum pressure action taking place in the concave portion spaces 30a of the drape forming mold 30. Hence, there will be no flaws or scratches resulted from scrubbing of the drape portions 20a on the molds. Consequently, it is possible to form fine patterns with high accuracy.

A ninth characteristic is based on the seventh characteristic, in which, in the drape forming step, the drape portions 20a are formed by press-adhering convex portions 31a/32a of the fine patterns of the drape forming mold 31/32 to the insulating resin film 20. According to this characteristic, together with the seventh characteristic, the formation of the drape portions can be ensured through press-adhering of the mold. Hence, it is possible to form the drape portions 20a corresponding to the fine patterns even in an insulating resin film having poor flexibility.

A tenth characteristic is based on any one of the foregoing characteristics, in which the press-adhering in the molding step is conducted through either or both of suction from the forming mold 10 side and air-compression from the drape forming mold 30 side. According to this characteristic, together with any one of the foregoing characteristics, press-adhering to the fine patterns of the forming mold 10 can be conducted without any physical contact. Hence, it is possible to form fine patterns with higher accuracy.

An eleventh characteristic is based on any one of the foregoing characteristics, in which the drape forming step and the molding step are repeated alternately in succession. According to this characteristic, together with any one of the foregoing characteristics, the drape portions can be formed gradually while the steps are repeated. Hence, not only can the drape portions be molded uniformly with accuracy, but also the drape portions can be formed uniformly in a reliable manner in an insulating resin film (even if it has a poor moldability).

A twelfth characteristic is based on any one of the foregoing characteristics, in which, in the drape forming step, the drape forming mold 30/31/32 is heated to pre-heat the insulating resin film 20. According to this characteristic, together with any one of the foregoing characteristics, the drape forming step is conducted also as the pre-heating step for molding. Hence, not only can the molding be conducted in a reliable manner, but also draping itself can be conducted in a shorter time in a reliable manner due to the heating in the drape forming step.

A thirteenth characteristic is based on any one of the foregoing characteristics, in which a step of cooling the forming mold 10 is further included after the molding step. According to this characteristic, together with any one of the foregoing characteristics, the insulating resin film softened due to previous heating effect is cured. Hence, the molded fine patterns can be maintained in the exact shape.

A fourteenth characteristic is based on any one of the foregoing characteristics, in which the fine concavo-convex patterns have a pitch and a depth both in a range from 10 to 500 µm. According to this characteristic, together with any one of the foregoing characteristics, it is possible to obtain an insulating resin film having fine concavo-convex patterns with a pitch and a depth both in a range from 10 to 500 µm through molding using a forming mold. Hence, the productivity can be improved. Also, since fine patterns can be formed under little material restriction, the method is useful as a method for forming fine patterns in a substrate, so that it can be used in a wide range of applications.

### [Example]

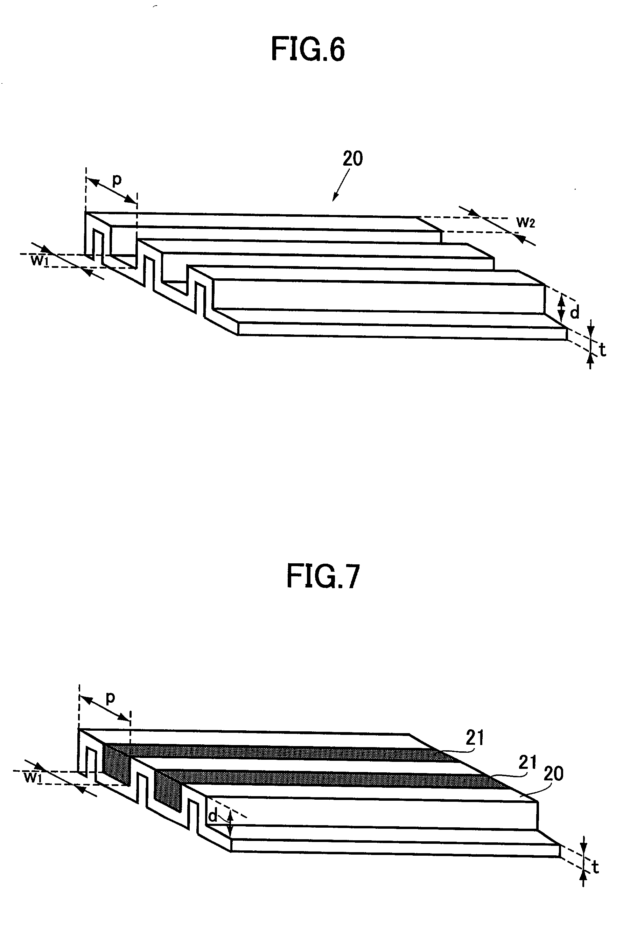

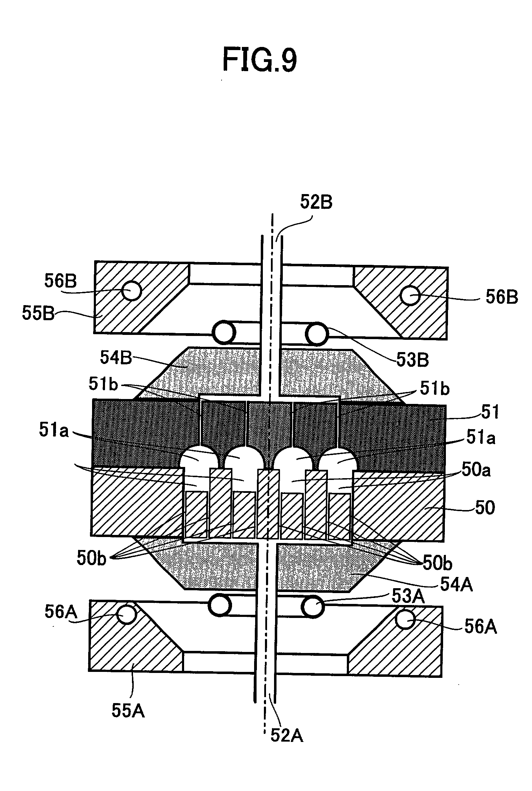

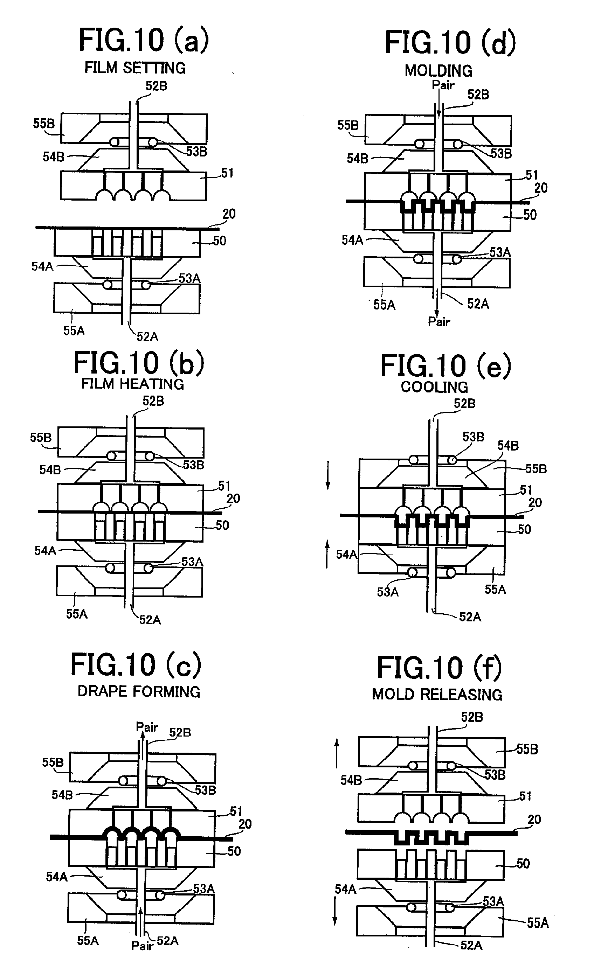

The following description will describe a more concrete example of the foregoing embodiments with reference to the drawings . Fig. 6 is an explanatory view showing an example dimension of the insulating resin film 20 having molded fine patterns. In this example, a thermoplastic polyimide film is adopted as a film material, and fine patterns are molded by the forming method as shown in Figs. 10 (a) through 10 (f) using a molding apparatus shown in Fig. 9. Besides the thermoplastic polyimide film, the film material can be a heat-resistant resin film made of any of polyamide, polybenzimidazole, polyester, polyimidazole, polyphenylene sulfide, polyamide-imide, polyether imide, polyether ketone, and polysulfone. In this example, the fine patterns are formed in stripes with a gib-shaped cross section, and the pitch p is set to 50 µm, the depth d to 25 µm, the width w1 (= w2) to 25 µm, and the thickness t to 15µm. In this manner, molding with high accuracy can be achieved for a molding pattern in which the depth d and the width w1 are equal. The gib-shaped cross section is shown as an example. However, the cross section can be changed to a V-shaped or U-shaped cross section by changing the shape of the molding slots 10a (see Figs. 2(a) through 5(d)) of the forming mold 10 as needed. Also, the cross section may have more than one of these shapes depending on the forming mold 10.

Fig. 7 is a view showing a high-density wiring electronic component in which a conducting member 21 is provided in the fine patterns of the insulating resin film 20 shown in Fig. 6. The conducting member 21 is provided inside the stripes of fine patterns having the pitch p, the depth d, and the width w1 molded to the insulating resin film 20. The conducting member 21 may be provided by filing the recess portions of the stripes of fine patterns with a conducting paste or by forming a metallic deposit therein. With the use of such a high-density wiring electronic component, the width and the height of the conducting member 21 and the intervals of the adjacent wires can be made substantially equal to one another. Therefore, a low-resistance high-density wiring can be achieved.

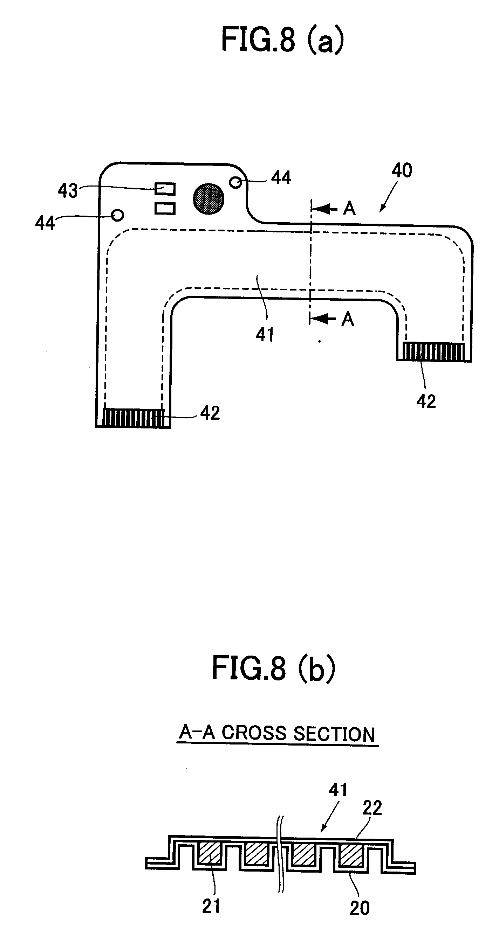

Figs. 8 (a) and 8 (b) are explanatory views showing a flexible wiring board as an example of the high-density wiring electronic component employing the insulating resin film 20. A flexible wiring board 40 shown in Fig. 8(a) is composed of an insulating resin film having a wiring region 41 and a connector portion 42 at either end. The reference numeral 42 denotes an electronic component, such as a CRL, or a semiconductor chip, mounted on the substrate made of the insulating resin film. The reference numeral 44 denote a registration hole for use in mounting electronic components. Fig. 8 (b) shows a cross section taken along the line A-A in the wiring region 41 of the flexible wiring board 40 as described above. The wiring region 41 is of the same structure as that shown in Fig. 7, in which the conducting member 21 is provided inside the fine patterns molded to the insulating resin film 20, and an insulating member 22 covers the periphery.

Fig. 9 is a view showing an example of a molding apparatus for molding such an insulating resin film 20. In the drawing, the reference numeral 50 denotes a forming mold, and the forming mold 50 is provided with molding slots 50a corresponding to the fine concavo-convex patterns, and vent holes 50b communicated with the respective molding slots 50a in the corners. The reference numeral 51 denotes a drape forming mold, and is provided with concave portion spaces 51a at the positions corresponding to the molding slots 50a in a one-to-one correspondence. Vent holes 51b communicate with the respective concave portion spaces 51a.

A pressurizing and sucking channel 52A communicates with the vent holes 50b in the forming mold 50, and a pressurizing and sucking channel 52B communicates with the vent holes 51b in the drape forming mold 51. Electromagnetic induction coils 53A and 53B serving as heat sources are provided below the forming mold 50 and above the drape forming mold 51, respectively. Heat is thereby transferred to the forming mold 50 and the drape forming mold 51 through heat transferring members 54A and 54B, respectively. Alpha-numerals 55A and 55B denote heat releasing blocks brought into contact with or attached in a detachable manner to the forming mold 50 and the drape forming mold 51, respectively. The heat releasing blocks 55A and 55B are provided with cooling water channels 56A and 56B, respectively.

The following description will describe an example of the method of forming fine patterns using the molding apparatus described as above with reference to Figs. 10(a) through 10(f).

Film setting step (Fig. 10(a)): both the forming mold 50 and the drape forming mold 51 are opened, and the insulating resin film 20 (polyimide film) is placed on the forming mold 50 to be present between the two molds. At this time, the electromagnetic induction coils 53A and 53B as the heat sources are in their OFF state, a supply of pressure to the pressurizing and sucking channels 52A and 52B is stopped, and the heat releasing blocks 55A and 55B are spaced apart from the forming mold 50 and the drape forming mold 51, respectively.

Film heating step (Fig. 10(b)): the drape forming mold 51 is press-adhered to the insulating resin film 20 placed on the forming mold 50. Then, the electromagnetic induction coils 53A and 53B as the heat sources are turned ON to heat the forming mold 50 and the drape forming mold 51 through the heat transferring members 54A and 54B, respectively, and the insulating resin film 20 is thereby heated. The heating temperature is 250 to 400°C. At this time, the supply of pressure to the pressurizing and sucking channels 52A and 52B is still in stopped state, while the heat releasing blocks 55A and 55B are spaced apart from the forming mold 50 and the drape forming mold 51, respectively.

Drape forming step (Fig. 10(c)): the ON-state of the electromagnetic induction coils 53A and 53B is maintained from the film heating step of Fig. 10(b), and a compressed-air Pair of 3 to 10 atmospheres is applied to the pressurizing and sucking channel 52A on the forming mold 50 side, and at the same time, a sucking pressure Pair of the same atmospheres is applied to the pressurizing and sucking channel 52B on the drape forming mold 51 side. The heated insulating resin film 20 is thereby sucked locally inside the concave portion spaces 51a of the drape forming mold 51. Fine drape portions corresponding to the molding slots 50a of the forming mold 50 are thereby formed in the insulating resin film 20. Then, the heat releasing blocks 55A and 55B are spaced apart from the forming mold 50 and the drape forming mold 51, respectively.

Molding step (Fig. 10 (d)) : The pressure supplying conditions are inverted while the heating conditions in the Fig. 10(c) is maintained. Namely, a sucking pressure Pair of 3 to 10 atmospheres is applied to the pressurizing and sucking channel 52A on the forming mold 50 side, and at the same time, a compressed-air Pair of the same atmospheres is applied to the pressurizing and sucking channel 52B on the drape forming mold 51 side. The fine drape portions formed in the insulating resin film 20 are thereby pulled inside the molding slots 50a of the forming mold 50, and press-adhered to the inner surface of the molding slots 50a. By maintaining this condition, it is possible to form the foregoing fine patterns in the order of microns in the insulating resin film 20.

Cooling step (Fig. 10(e)): A supply of pressure to the pressurizing and sucking channels 52A and 52B is stopped, and the electromagnetic induction coils 53A and 53B are turned OFF. At the same time, the heat releasing blocks 55A and 55B, in which cooling water is supplied to the cooling channels 56A and 56B, are brought into contact with the forming mold 50 and the drape forming mold 51, respectively. The molded insulating resin film 20 is thereby cooled and solidified rapidly, which allows the molded fine patterns to be maintained in the exact shape.

Mold releasing step (Fig. 10 (f)): The electromagnetic induction coils 53A and 53B are turned OFF, a supply of pressure to the pressurizing and sucking channels 52A and 52B is stopped, and driving of cooling water in the heat releasing blocks 55A and 55B is stopped. Then, the heat releasing blocks 55A and 55B are released and the forming mold 50 and the drape forming mold 51 are opened. Then, the completely molded insulating resin film 20 is released from the molds.

According to the example described as above, there can be offered the operational advantages as follows.
(1) Since an insulating resin film having fine patterns in the order of microns can be formed through the vacuum pressure forming processing using a forming mold, the productivity of such an insulating resin film can be improved significantly.
(2) Since processing having dependence on the properties of materials, such as etching, is not performed, the constraints of the kinds of insulating materials are eased, and it is thus possible to form an insulting resin film which can be used in a wide range of applications.
(3) By forming fine drape portions corresponding to the fine patterns of the forming mold in an insulating resin film through the use of the drape forming mold, draping processing can be performed with uniformity corresponding to the fine patterns. It is thus possible to transfer the fine patterns to the insulating resin film with high accuracy through the use of the forming mold.
(4) By forming the fine drape portions, adaptation of the insulating resin film to a forming mold having fine three-dimensional shapes can be improved. Hence, a molded article with excellent accuracy in shape can be obtained. It is thus possible to mold fine patterns having a cross section of various shapes.
(5) Since molding can be achieved gradually by repeating the formation of the fine drape portions and the molding to the forming mold in succession, the method can be applied to film materials or shapes which are otherwise hard to mold.
(6) Since the fine patterns are molded through induction heating while the insulting resin film is set between the forming mold and the drape forming mold, and the insulating resin film is cooled immediately after the molding through physical contact with the heat releasing blocks, the molding time can be shortened.
(7) Since rapid cooling is possible after the fine patterns are molded, the molded fine patterns can be maintained in the exact shape.
(8) Since the vent holes are provided at the corners of the molding slots corresponding to the gib-shaped cross section to be transferred, the fine drape portions formed in the insulating resin film can adhere to the entire inner surface of the molding slots with high accuracy. Hence, the transferring accuracy can be improved.

While there has been described what are at present considered to be preferred embodiments of the present invention, it will be understood that various modifications may be made thereto, and it is intended that the appended claims cover all such modifications as fall within the true spirit and scope of the invention.

## Claims

1. An insulating resin film (20) molded to have concavo-convex patterns at a pitch of 10 to 500 µm through vacuum pressure forming.

2. An insulating resin film (20) molded to have concavo-convex patterns having a depth of 10 to 500 µm at a pitch of 10 to 500 µm through vacuum pressure forming.

3. The insulating resin film (20) according to claim 1 or 2, wherein said concavo-convex patterns have any of gib-shaped, V-shaped, and U-shaped cross sections, either solely or in combination.

4. A high-density wiring electronic component, comprising a conducting member provided inside concave portions of the concavo-convex patterns of said insulating resin film (20) according to any one of claims 1 through 3.

5. The high-density wiring electronic component according to claim 4, wherein said insulating resin film (20) has a thickness of 5 to 500 µm.

6. The high-density wiring electronic component according to claim 4 or 5, wherein said insulating resin film (20) is made of at least one selected from the group consisting of polyimide, polyamide, polybenzimidazole, polyester, polyimidazole, polyphenylene sulfide, polyamide-imide, polyether imide, polyether ketone, and polysulfone.

7. A method of forming fine patterns of an insulating resin film (20), the method comprising:
a step of placing the insulating resin film (20) on a forming mold (10) provided with fine concavo-convex patterns formed at a predetermined pitch;
a drape forming step of placing a drape forming mold (30) provided with fine concavo-convex patterns corresponding to the fine patterns of said forming mold (10) on or above said insulating resin film (20), and forming drape portions (20a) corresponding to the fine patterns of said forming mold (10) in said insulting resin film (20); and
a molding step of molding said insulating resin film (20) to the fine concavo-convex patterns by press-adhering said respective drape portions to the corresponding fine patterns of said forming mold (10).

8. The method of forming fine patterns of an insulating resin film (20) according to claim 7, wherein, in said drape forming step, said drape portions are formed in concave portion spaces of the fine patterns of said drape forming mold (30) through either or both of suction from said drape forming mold side and air-compression from said forming mold side.

9. The method of forming fine patterns of an insulating resin film (20) according to claim 7, wherein, in said drape forming step, said drape portions are formed by press-adhering convex portions of the fine patterns of said drape forming mold to said insulating resin film (20).

10. The method of forming fine patterns of an insulating resin film (20) according to any one of claims 7 through 9, wherein the press-adhering in said molding step is conducted through either or both of suction from said forming mold side and air-compression from said drape forming mold side.

11. The method of forming fine patterns of an insulating resin film (20) according to any one of claims 7 through 10, wherein said drape forming step and said molding step are repeated alternately in succession.

12. The method of forming fine patterns of an insulating resin film according to any one of claims 7 through 11, wherein, in said drape forming step, said drape forming mold (30) is heated to pre-heat said insulating resin film (20).

13. The method of forming fine patterns of an insulating resin film (20) according to any one of claims 7 through 12, further comprising:
a step of cooling said forming mold (10) after said molding step.

14. The method of forming fine patterns of an insulating resin film (20) according to any one of claims 7 through 13, wherein said fine concavo-convex patterns have a pitch and a depth both in a range from 10 to 500 µm.
